# EUROPEAN PATENT SPECIFICATION

(11) **EP 1 145 072 B1**
(45) Date of publication and mention of the grant of the patent: **07.05.2003**
(21) Application number: 99930511.3
(22) Date of filing: 22.06.1999
(51) Int. Cl.: G02F 1/00

(54) **METHOD OF ADDRESSING MICROENCAPSULATED DISPLAY MEDIA**
VERFAHREN ZUR ADRESSIERUNG MIKROGEKAPSELTER ANZEIGEMEDIA
METHODE D'ADRESSAGE D'UN AFFICHEUR A MICROCAPSULES

(30) Priority: 22.06.1998 US 90222 P; 14.07.1998 US 92742 P
(43) Date of publication of application: 17.10.2001
(73) Proprietor: E-Ink Corporation, Cambridge, MA 02138-1002 (US)
(72) Inventor: DRZAIC, Paul, Morgan Hill CA 95037 (US)
(74) Representative: Cole, David John
(86) International application number: US9914010
(87) International publication number: WO99067678

(56) References cited:
- EP-A- 0 362 928
- EP-A- 0 460 747
- WO-A-92/12453
- WO-A-93/18428
- WO-A-96/41372
- WO-A-97/04398
- WO-A-99/10769
- WO-A-99/63399
- NAKAMURA E ET AL: "Development of electrophoretic display using microcapsulated suspension" 1998 SID INTERNATIONAL SYMPOSIUM. DIGEST OF TECHNICAL PAPERS. VOL. 29, PROCEEDINGS OF SID'98. INTERNATIONAL SYMPOSIUM, ANAHEIM, CA, USA, 17-22 MAY 1998, pages 1014-1017, XP002114866 1998, Santa Anaheim, CA, USA, Soc. Inf. Display, USA
- R.R.SHIFFMAN, R.H.PARKER: "An electrophoretic image display with internal NMOS address logic and display drivers" PROCEEDINGS OF THE SID, vol. 25, no. 2, 1984, pages 105-115, XP002118363

## Description

The present invention relates to a method of forming an electronic display.

Encapsulated, particle-based displays offer a useful means of creating electronic displays. There exist many versions of encapsulated particle-based displays including: encapsulated electrophoretic displays; encapsulated suspended particle displays; and rotating ball displays.

Encapsulated, particle-based displays can be made highly reflective, bistable, and optically and electrically efficient. To obtain a high-resolution display, however, individual pixels of a display must be addressable without interference from adjacent pixels. One way to achieve this objective is to provide an array of nonlinear transistor elements, where one transistor is associated with each pixel. The addressing electrodes are connected to the pixel through the transistor.

Most examples of nonlinear elements to date have been fabricated using vacuum-deposited silicon on glass. This process is costly in addition to being complex. The complexity prevents large area devices from being readily constructed. In addition, it is difficult to create silicon transistors on plastic or other flexible film.

Several methods of fabricating electrical devices such as transistors using thin-film fabrication technology and transferring the fabricated devices to another device are known. For example, US-A-5 362 671 describes a lift-off process for fabricating transistors and drive circuitry for a liquid crystal display on a silicon wafer, and then transferring the transistors and drive circuitry to an optically transparent substrate to form the display. The liquid crystal display prepared according to this method requires the silicon wafer to undergo a "rubbing" process to align the liquid crystals, which can cause either mechanical or static electric damage to the transistor. Additionally, this transfer process could be used to create flexible active matrix panels, which could be the basis of a film-based liquid crystal panel. Most liquid crystal devices, however, are not readily compatible with flexible substrates, so that displays of this type have not been commercialized.

WO 92 12553 A describes a similar process for forming a display which starts with a first substrate having a release layer disposed thereon. An array of non-linear circuit elements is formed on this first substrate, separated therefrom and placed on a second substrate.

Another transfer method, commercialized by Alien Technology of Hayward, California, is described in WO 96 41372 A. According to this method, discrete circuit elements formed on a silicon wafer are separated from the wafer. The separated circuit elements are dispersed as slurry. The slurry containing the elements is brought in contact with a substrate, which comprises a plurality of indentations. Each indentation is sized and shaped to receive an element. With flow and agitation, the discrete elements fall into the indentations and can form a large area array of discrete elements. Once the discrete elements are bonded to the appropriate conduction lines, the discrete elements can be used to address a display. This is a challenging technology, however, as it is important that reliable connections are made between the discrete elements and the conductive traces. For transmissive display technologies, however, there are limitations on the type, thickness, and number of conductive traces, which can be used to make these connections, making high yields of working devices problematic. Additionally, while this technology could be used to create flexible backplanes, the display system suffers from the limited compatibility of most liquid crystal display technologies with flexible substrates.

Nakamura, E., et al., "Development of electrophoretic display using microencapsulated suspension", 1998 SID International Symposium, Digest of Technical Papers, Volume 29, Proceedings of SID '98, International Symposium, Anaheim, CA, USA, 17-22 May 1998, pages 1014-1017 (Society for Information Display), describes an electrophoretic display using a microcapsule technique. The electrophoretic display is composed of two films with electrodes and microencapsulated suspensions having a diameter of 40 to 60 micrometers sandwiched in between.

For both types of transfer technologies, there are circumstances in which there are substantial advantages in working with substrates that are not transparent and colorless including translucent, colored, or opaque materials. Polyimide films, for example, can withstand high temperatures but are strongly colored. Metal foils, with an appropriate insulating layer, are highly durable and can also withstand high temperatures. Neither substrate is readily compatible with transmissive display technologies, however, as the image quality of the transmissive display would be degraded or destroyed with these substrates. While some emissive display materials overcome some of these limitations, emissive displays suffer from high power consumption, compared to reflective displays.

There exists a need for active matrix displays prepared on flexible substrates, which have good performance, can be manufactured to provide a high yield, and which can be reflective in nature.

In one aspect, the invention provides a method of forming a display, the method comprising:
(a) providing a first substrate having a release layer disposed thereon;
(b) forming an array of non-linear circuit elements on the release layer;
(c) separating the array of non-linear circuit elements from the first substrate; and
(d) placing the array of non-linear circuit elements on a second substrate.
This method is characterized by placing the second substrate adjacent a surface of an encapsulated display medium comprising a plurality of capsules, each capsule comprising a plurality of particles dispersed in a fluid, with an adhesive layer being interposed between the second substrate and the surface of the display medium.

In this process, the non-linear circuit elements can be an array of thin-film silicon transistors or diodes.

The non-linear circuit elements can be formed on a silicon wafer. The second substrate can be glass, plastic, metal, or paper. The second substrate can also be flexible.

This invention also provides a method of forming a display, the method comprising:
(a) providing a plurality of non-linear circuit elements;
(b) placing the plurality of non-linear circuit elements in a slurry to form a mixture;
(c) providing a substrate comprising a plurality of impressions;
(d) placing the mixture on a substrate; and
(e) agitating the substrate such that the plurality of non-linear circuit elements fall in the plurality of impressions to form an array of non-linear circuit elements.
This method is characterized by placing the substrate on a surface of a display medium comprising a plurality of capsules, each capsule comprising a plurality of particles dispersed in a fluid, with an adhesive layer being interposed between the substrate and the surface of the display medium.

In this process, the non-linear circuit elements can be thin-film silicon transistors or silicon diodes, and the plurality of impressions can be sized and shaped to receive the plurality of non-linear circuit elements in an appropriate orientation.

In one embodiment, the non-linear circuit elements are first formed on the first substrate, and subsequently separated from the first substrate. The first substrate can be a silicon wafer. The non-linear elements can be separated from each other, or the first substrate, by being diced.

In another embodiment, the non-linear elements are formed on a first substrate comprising a sacrificial layer. In this embodiment, the non-linear elements are separated by etching the sacrificial layer to release the non-linear elements.

The substrate having the impressions can consist of glass, plastic, metal foil, paper, or silicon.

The display produced by the methods of the invention can further includes drive circuitry and/or logic circuitry disposed adjacent the substrate. In one embodiment, at least one non-linear circuit element includes an array of non-linear elements forming switches. In another embodiment, at least one non-linear circuit element includes an array of non-linear elements forming an addressing backplane for the display medium.

The present invention will be more fully understood from the following description of preferred embodiments, when read together with the accompanying drawings, in which:
Figure 1a shows a cross section view of an electronic display which can be formed according to one embodiment of the present invention.
Figure 1b shows a cross section view of a second electronic display which can be formed according to another embodiment of the present invention.
Figure 1c shows a top view of the electronic display of Figure 1b with the display medium and the first electrode removed.
Figure 1d shows a cross section view of another electronic display which can be formed according to one embodiment of the present invention.
Figure le shows a top view of a bottom substrate of another electronic display which can be formed according to one embodiment of the present invention.
Figure 1f shows a bottom view of a top substrate of an electronic display which can be formed according to one embodiment of the present invention.
Figure 2a shows a partial cross section view of an electronic display which can be formed according to one embodiment of the present invention.
Figure 2b shows a partial cross section view of an electronic display which can be formed according to another embodiment of the present invention.
Figure 3 shows a partial cross section view of an electronic display which can be formed according to another embodiment of the present invention.
Figure 4 shows a cross section view of a means for addressing an electronic display which can be formed according to one embodiment of the present invention.
Figures 5a and 5b show cross section views of a means for addressing an electronic display which can be formed according to another embodiment of the present invention.
Figure 6a illustrates connections between a transistor and electrodes of an electronic display.
Figure 6b illustrates connections between a diode and electrodes of an electronic display.
Figure 7 illustrates a process for making an electronic display of Figure 8 according to one embodiment of the present invention.
Figure 8 shows an electronic display made in accordance with the process of Figure 7.
Figure 9 illustrates a process for making an electronic display according to another embodiment of the present invention.

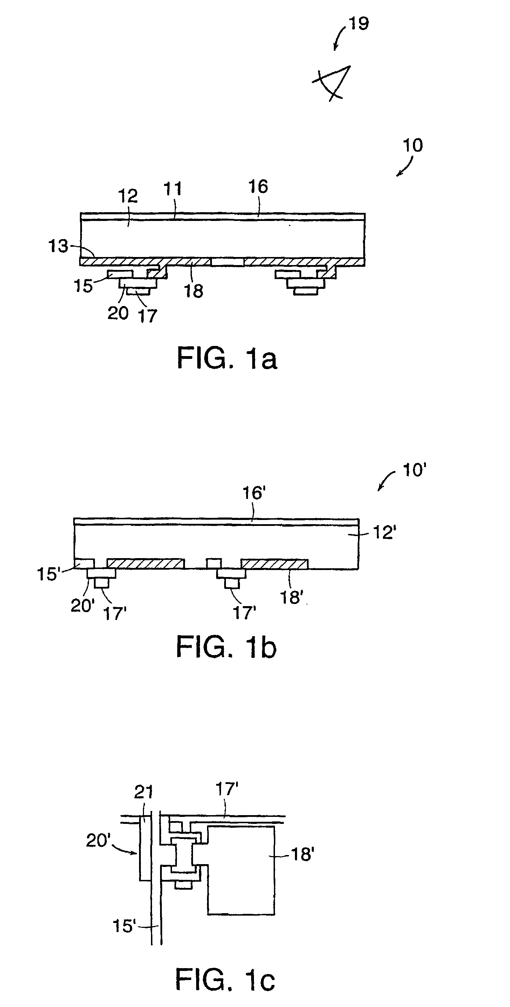

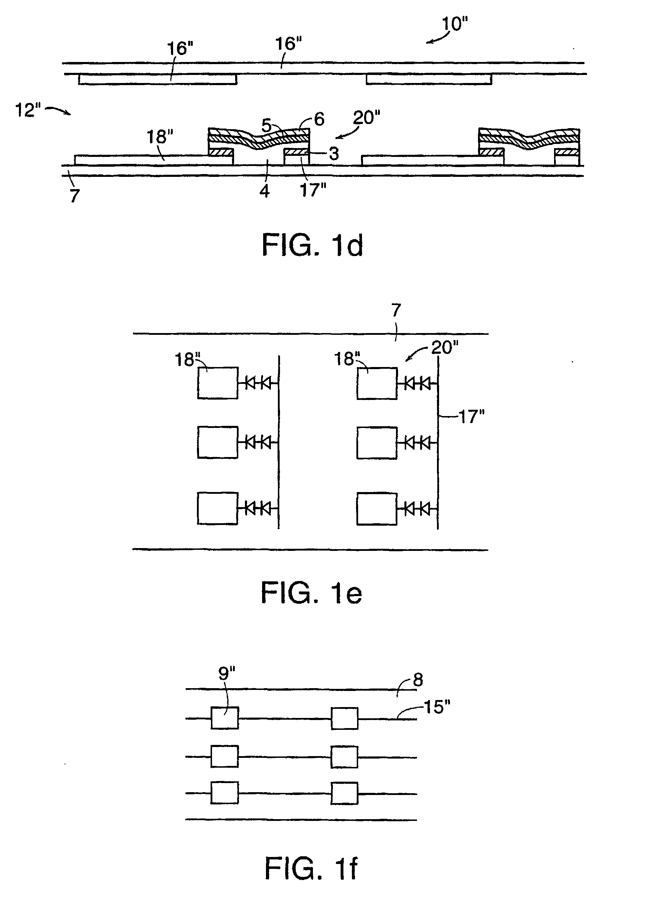

Referring to Figure 1a, an electronic display 10 includes a display medium 12, a first electrode 16, a second electrode 18, non-linear circuit elements 20, row electrodes 17, and column electrodes 15. The first electrode 16 is disposed on a first surface 11 of the display medium 12. In one embodiment, the first electrode 16 comprises a transparent, continuous electrode. The second electrode 18 disposed on a second surface 13 of the display medium 12 can comprise an array of patterned pixel electrodes 18. Each patterned electrode 18 defines a pixel of the display 10. In the embodiment of Figure 1a, the non-linear circuit elements 20 are transistors. The non-linear circuit elements 20 can be an array of non-linear circuit elements 20. The transistors 20 are located underneath the pixel electrodes 18. Each transistor 20 is electrically connected to a pixel electrode 18 to address a pixel. The row electrodes 17 can be an array of row electrodes. A row electrode 17 is electrically connected to all the transistors 20 in that row. The column electrodes 15 can be an array of column electrodes. A column electrode 15 is electrically connected to all the transistors 20 in that column.

In the embodiment of Figure 1a, the transistors 20 are located on the backside of the display 10 from the standpoint of the viewer 19. Alternatively, the transistors 20 can be located on the front side of the display 10. In this embodiment, transparent pixel electrodes would be positioned on the first surface 11 of the display medium 12, while the continuous electrode would be positioned on the second surface 13 of the display medium 12. The continuous electrode need not be transparent.

In one embodiment, the electronic display 10 can be reflective. In this embodiment, the size of the transistors 20 positioned on the backside of the display 10 does not affect the ability of the viewer 19 to view the display 10. Therefore, the size of the transistor 20 can be determined based on manufacturing considerations and transistor performance. The size of the transistor 20 can be in the range from about 1% to about 100% of the area of the pixel the transistor 20 addresses. In another embodiment, the electronic display 10 can be transmissive. In this embodiment, the transistors 20 can impede the ability of the viewer 19 to view the display 10. Therefore, the transistors 20 are made as small as possible. In one embodiment, the size of the transistor 20 is less than 50% of the area of the pixel addressed by the transistor 20. In a preferred embodiment, the size of the transistor 20 is less than 20% of the area of the pixel addressed by the transistor 20. In a more preferred embodiment, the size of the transistor 20 is less than 5% of the area of the pixel addressed by the transistor 20.

Referring to Figures 1b and 1c, an electronic display 10' includes a display medium 12' having a plurality of pixels defined by the second electrodes 18'. The display 10' further includes the first electrode 16', the transistors 20', the row electrodes 17', the column electrodes 15', and an insulator 21. In this embodiment, the transistors 20' are positioned adjacent the pixel electrodes 18'.

In another embodiment, shown in Figure 1d, the nonlinear circuit element 20" is a diode. There are a number of means of creating diode-type arrays. In the embodiment of Figure 1d, a back-to-back diode 20" has a patterned stack of a first conductive layer 3, undoped amorphous semiconductor 4, doped amorphous semiconductor 5, and a second conductive layer 6. A bottom substrate 7 comprises a series of conductive pixels 18" and a back to back diode 20" electrically connected to each pixel 18". The diodes 20" are connected in a series by a column electrode 17" as shown in Figure le. On the top substrate 8, rows of conducting pixels 9" are connected electrically by a series of rows of conductive material 15" as shown in Figure 1f. In the completed device, the pixels 9", 18" on the top and bottom substrates 8, 7 are arranged to overlap spatially, with the conductive traces connecting the pixels arranged perpendicular to each other on the top and bottom substrates 8, 7. Alternatively, diodes 20" can be connected to row electrodes on the bottom substrate 8 and the top substrate 7 can include column electrodes. Various types of diode arrays such as metal-insulator-metal diode array or diode rings and means of addressing these diodes are well known to those skilled in the art.

The display medium 12 is a particle-based display medium. In one detailed embodiment, the particle-based display medium comprises an electronic ink. An electronic ink is an optoelectronically active material which comprises at least two phases: an electrophoretic contrast medium phase and a coating/binding phase. The electrophoretic phase comprises, in some embodiments, a single species of electrophoretic particles dispersed in a clear or dyed medium, or more than one species of electrophoretic particles having distinct physical and electrical characteristics dispersed in a clear or dyed medium. The electrophoretic phase is encapsulated, that is, there is a capsule wall phase between the two phases. The coating/binding phase includes, in one embodiment, a polymer matrix that surrounds the electrophoretic phase. In this embodiment, the polymer in the polymeric binder is capable of being dried, crosslinked, or otherwise cured as in traditional inks, and therefore a printing process can be used to deposit the electronic ink onto a substrate.

The optical quality of an electronic ink is quite distinct from other electronic display materials. The most notable difference is that the electronic ink provides a high degree of both reflectance and contrast because it is pigment based (as are ordinary printing inks). The light scattered from the electronic ink comes from a very thin layer of pigment close to the top of the viewing surface. In this respect it resembles an ordinary, printed image. Also, electronic ink is easily viewed from a wide range of viewing angles in the same manner as a printed page, and such ink approximates a Lambertian contrast curve more closely than any other electronic display material. Since electronic ink can be printed, it can be included on the same surface with any other printed material, including traditional inks. Electronic ink can be made optically stable in all display configurations, that is, the ink can be set to a persistent optical state. Fabrication of a display by printing an electronic ink is particularly useful in low power applications because of this stability.

Electronic ink displays are novel in that they can be addressed by DC voltages and draw very little current. As such, the conductive leads and electrodes used to deliver the voltage to electronic ink displays can be of relatively high resistivity. The ability to use resistive conductors substantially widens the number and type of materials that can be used as conductors in electronic ink displays. In particular, the use of costly vacuum-sputtered indium tin oxide (ITO) conductors, a standard material in liquid crystal devices, is not required. Aside from cost savings, the replacement of ITO with other materials can provide benefits in appearance, processing capabilities (printed conductors), flexibility, and durability. Additionally, the printed electrodes are in contact only with a solid binder, not with a fluid layer (like liquid crystals). This means that some conductive materials, which would otherwise dissolve or be degraded by contact with liquid crystals, can be used in an electronic ink application. These include opaque metallic inks for the rear electrode (e.g., silver and graphite inks), as well as conductive transparent inks for either substrate. These conductive coatings include conducting or semiconducting colloids, examples of which are indium tin oxide and antimony-doped tin oxide. Organic conductors (polymeric conductors and molecular organic conductors) also may be used. Polymers include, but are not limited to, polyaniline and derivatives, polythiophene and derivatives, poly(3,4-ethylenedioxythiophene) (PEDOT) and derivatives, polypyrrole and derivatives, and polyphenylenevinylene (PPV) and derivatives. Organic molecular conductors include, but are not limited to, derivatives of naphthalene, phthalocyanine, and pentacene. Polymer layers can be made thinner and more transparent than with traditional displays because conductivity requirements are not as stringent.

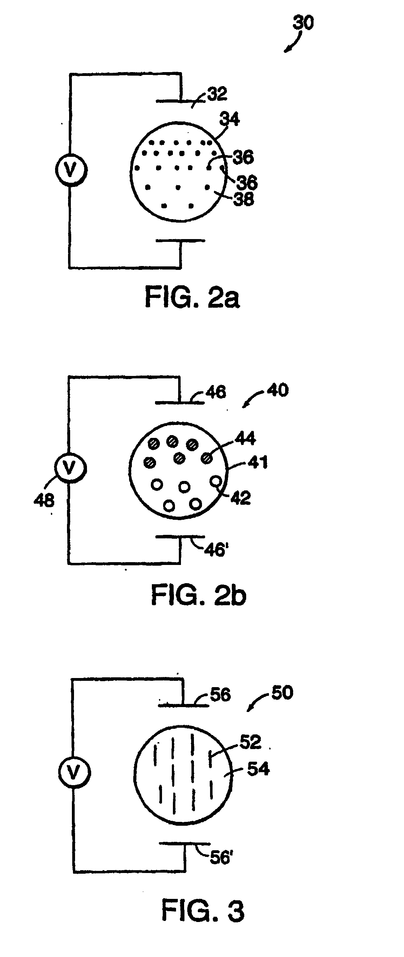

Figure 2a shows a cross-section of an electrophoretic display 30 constructed using electronic ink. The binder 32 includes at least one capsule 34, which is filled with a plurality of particles 36 and a dyed suspending fluid 38. In one embodiment, the particles 36 are titania particles. When a direct-current electric field of the appropriate polarity is applied across the capsule 34, the particles 36 move to the viewed surface of the display and scatter light. When the applied electric field is reversed, the particles 36 move to the rear surface of the display and the viewed surface of the display then appears dark.

Figure 2b shows a cross-section of another electrophoretic display 40 constructed using electronic ink. This display comprises a first set of particles 42 and a second set of particles 44 in a capsule 41. The first set of particles 42 and the second set of particles 44 have contrasting optical properties. For example, the first set of particles 42 and the second set of particles 44 can have differing electrophoretic mobilities. In addition, the first set of particles 42 and the second set of particles 44 can have contrasting colors. For example, the first set of particles 42 can be white, while the second set of particles 44 can be black. The capsule 41 further includes a substantially clear fluid. The capsule 41 has electrodes 46 and 46' disposed adjacent it. The electrodes 46, 46' are connected to a source of voltage 48, which may provide an electric field to the capsule 41. In one embodiment, upon application of an electric field across the electrodes 46, 46', the first set of particles 42 move toward electrode 46', while the second set of particles 44 move toward electrode 46. In another embodiment, upon application of an electric field across the electrodes 46, 46', the first set of particles 42 move rapidly toward electrode 46', while the second set of particles 44 move only slowly or not at all towards electrode 46, so that the first set of particles packs preferentially at the microcapsule surface adjacent to electrode 46'.

Figure 3 shows a cross-section of a suspended particle display 50. The suspended particle display 50 includes needle-like particles 52 in a transparent fluid 54. The particles 52 change their orientation upon application of an AC field across the electrodes 56, 56'. When the AC field is applied, the particles 52 are oriented perpendicular with respect to the display surface and the display appears transparent. When the AC field is removed, the particles 52 are randomly oriented and the display 50 appears opaque.

The electrophoretic and suspended particle displays provided in Figures 2a-2b and 3 are exemplary only, and other electrophoretic displays can be used in accordance with the present invention.

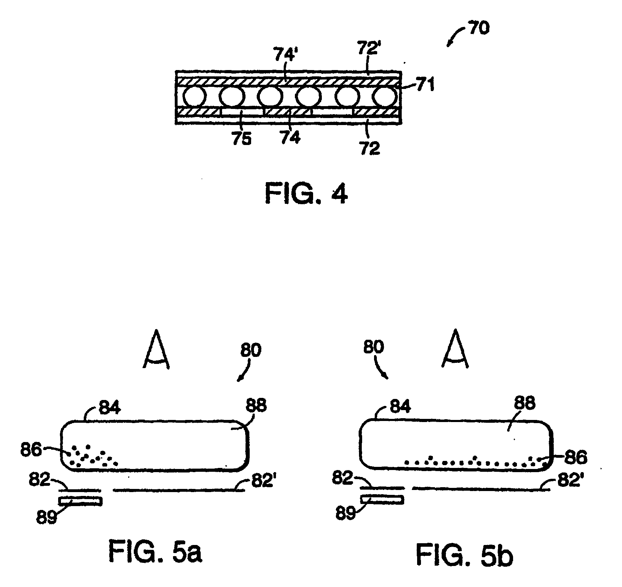

An electronic display can be addressed in a variety of ways. In one embodiment, the display medium 71 is sandwiched between two pieces of glass 72, 72' as shown in Figure 4. Each piece of glass has an etched, clear electrode structure 74, 74' formed using indium tin oxide. The first electrode 74 controls the pixels of the display 70 that may be addressed, that is changed from one visible state to another. A second electrode 74', sometimes called a counter electrode, addresses all the display pixels as one large electrode, and is generally designed so that the placement of the rear electrode wire connections do not produce any unwanted visible changes in the appearance of the display medium. In one embodiment, a masking element can be placed within the display to hide the presence of electrode wire connections. In this embodiment, the transistors 75 are connected to the first electrodes 74. Alternatively, the second electrode 74' can also be patterned to control specific segments of the displays 70.

An alternate means for addressing an encapsulated electrophoretic display structure is also described in Figures 5a and 5b. In this embodiment, electrodes 82, 82' are disposed on only one side of a display 80, allowing the display 80 to be rear-addressed without a front electrode. Utilizing only one side of the display 80 for electrodes 82, 82' simplifies fabrication of displays 80. For example, if the electrodes 82, 82' are disposed on only the rear side of a display 80, both of the electrodes 82, 82' can be fabricated using opaque materials, because the electrodes 82, 82' do not need to be transparent.

Figure 5a depicts a single capsule 84 of an encapsulated display medium. In brief overview, the embodiment depicted in Figure 5a includes a capsule 84 containing at least one particle 86 dispersed in a suspending fluid 88. The capsule 84 is addressed by a first electrode 82 and a second electrode 82'. The first electrode 82 is smaller than the second electrode 82'. The first electrode 82 and the second electrode 82' may be set to voltage potentials which affect the position of the particles 86 in the capsule 84. A transistor 89 is connected to the first electrode 82.

The electrodes 82, 82' should be sized and positioned appropriately so that together they address the entire capsule 84. There may be exactly one pair of electrodes 82, 82' per capsule 84, or multiple pairs of electrodes per capsule 84. In the embodiment shown in Figures 5a and 5b, the capsule 84 has a flattened, rectangular shape. In these embodiments, the electrodes 82, 82' should address most, or all, of the flattened surface area adjacent the electrodes 82, 82'. The smaller electrode 82 is at most one-half the size of the larger electrode 82'. In preferred embodiments the smaller electrode 82 is one-quarter the size of the larger electrode 82'; in more preferred embodiments the smaller electrode 82 is one-eighth the size of the larger electrode 82'. In even more preferred embodiments, the smaller electrode 82 is one-sixteenth the size of the larger electrode 82'. It should be noted that reference to "smaller" in connection with the electrode 82 means that the electrode 82 addresses a smaller amount of the surface area of the capsule 84, not necessarily that the electrode 82 is physically smaller than the larger electrode 82'. For example, multiple capsules may be positioned such that less of each capsule is addressed by the "smaller" electrode, even though both electrodes are equal in size.

Electrodes may be fabricated from any material capable of conducting electricity so that electrode 82, 82' may apply an electric field to the capsule 84. As noted above, the rear-addressed embodiments depicted in Figures Sa and 5b allow the electrodes 82, 82' to be fabricated from opaque materials such as solder paste, copper, copper-clad polyimide, graphite inks, silver inks and other metal-containing conductive inks. Alternatively, electrodes may be fabricated using transparent materials such as indium tin oxide and conductive polymers such as polyaniline or polythiophenes. Electrodes 82, 82' may be provided with contrasting optical properties. In some embodiments, one of the electrodes has an optical property complementary to optical properties of the particles 86.

The means of addressing an electronic display provided in Figures 4, and Figures 5a and 5b are exemplary only. Other means of addressing an electronic display can be used in accordance with the present invention, including using non-linear circuit elements.

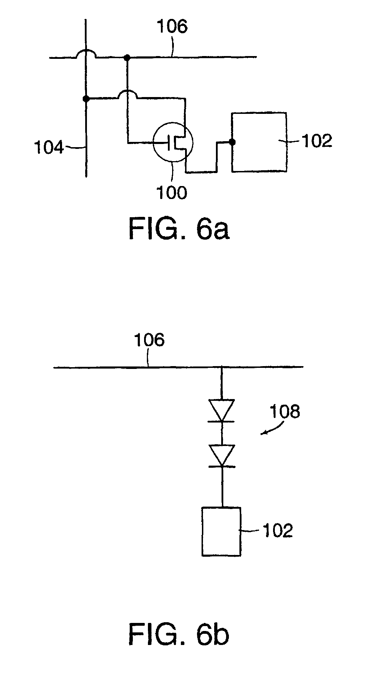

In one embodiment, the non-linear circuit elements 20 comprise transistors. Referring to Figure 6a, each transistor 100 is electrically connected to a pixel electrode 102, a column electrode 104, and a row electrode 106. The pixel electrode 102 is connected to the drain of the transistor 100. The column electrode 104 is connected to the source of the transistor 100. The row electrode 106 is connected to the gate of the transistor 100.

In another embodiment, the non-linear circuit elements comprise diodes. Referring to Figure 6b, a back-to-back diode 108 is electrically connected to a pixel electrode 102 and a row electrode 106. Other diode structures such as ring diode structures, and metal-insulator-metal, other transistor-like devices and/or varistors can also be used as non-linear circuit elements in accordance with the present invention.

According to the present invention, an electronic display can be prepared by fabricating non-linear elements using a thin-film fabrication technology and transferring the fabricated non-linear elements to an encapsulated display medium. As used herein, the term "thin-film technology" refers to one or more layers of semiconducting materials, deposited in layers less than about one micron in thickness.

In one embodiment, an electronic display is fabricated using a lift-off process. In broad overview, the lift-off process refers to a thin-film fabrication process in which a thin release layer is positioned between a substrate and an epitaxial film and the release layer is etched away to allow the epitaxial layer to be separated from the substrate. The epitaxial layer can be used to form devices such as transistors and diodes.

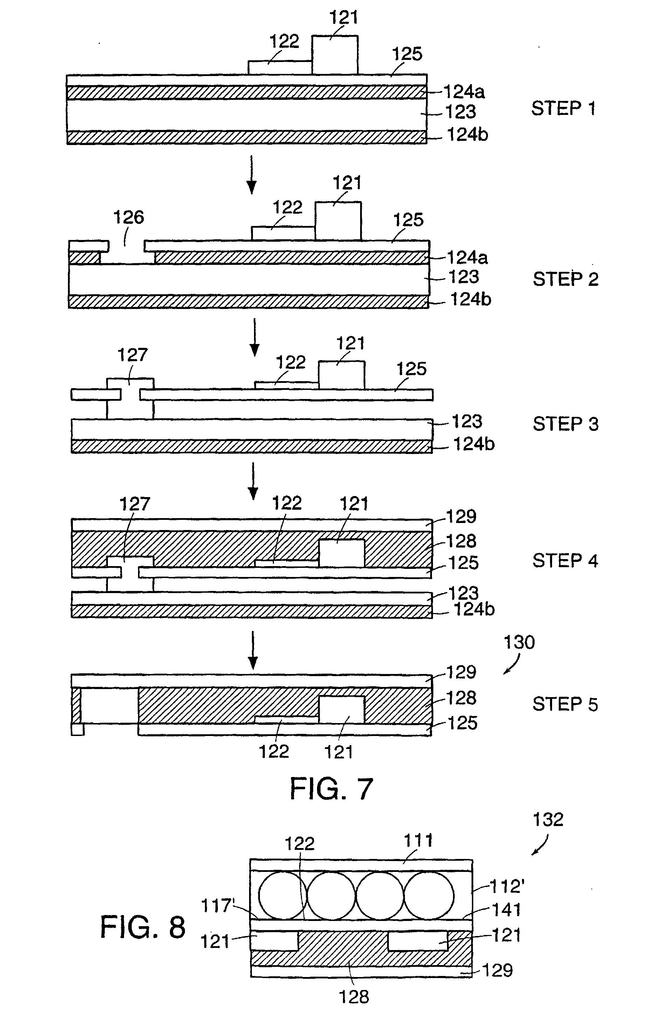

In one detailed embodiment, an electronic display is fabricated using a lift-off process illustrated in Figure 7. Nonlinear circuit element 121 such as a transistor or a diode and electrode 122 (i.e., column electrode, row electrode and/or pixel electrode) are fabricated on a silicon wafer 123 having oxide layers 124a, 124b and a silicon layer 125 (step 1). For illustration purpose, Figure 7 shows only a single transistor. An electronic display fabricated using the lift-off process can have multiple elements and electrodes. The oxide layer 124a and the silicon layer 125 are etched to expose an opening 126 (step 2). The oxide layer 124a functions as the release layer. A support member 127 is deposited on the silicon wafer 123 through the opening 126, and the oxide layer 124a is etched away (step 3). An epoxy layer 128 which can be cured with ultraviolet light is used to attach an optically transmissive substrate 129 to the nonlinear element 121, the electrode 122, and the support post 127 (step 4). The optically transparent substrate 129 can be glass or plastic. The epoxy layer 128 adjacent the nonlinear element 121 and the electrode 122 is cured while the rest of the epoxy layer 128 remains uncured. The substrate 123 and the support post 127 are removed (step 5).

While this example describes generally how transistors using this lift-off technique are formed, other semiconductor devices useful for addressing displays can be formed using similar methods.

Referring to Figure 8, an assembly 130 comprising the non-linear circuit elements 121 and the electrodes 122 are placed on the second surface 117' of the encapsulated display medium 112'. The encapsulated display medium 112' can be previously fabricated on a substrate. An adhesive layer 141 is used to help bind the encapsulated display medium 112' to the nonlinear circuit elements 121. This adhesive layer 141 not only serves to bind the two portions of the display132 together, but may also serve to stabilize the encapsulated display medium layer 112', the nonlinear array 121, or both.

In one example, the encapsulated display medium 112' can be fabricated on a substrate comprising a top electrode 111. The top electrode 111 can be provided by printing, evaporation, sputtering or any other suitable method known to those skilled in the art for providing a conductive coating. Printable electrode structures for displays are described in commonly owned US-A-6 177 921. In one detailed embodiment, the encapsulated display medium 112' comprises an electronic ink. The electronic ink can be printed on the substrate in a variety of ways including screen printing, ink jet printing, and deposition. Details of these printing methods are described in commonly owned US-A-6 120 588.

### Materials for use in Electrophoretic Displays

Useful materials for constructing the above-described encapsulated electrophoretic displays are discussed below. Many of these materials will be known to those skilled in the art of constructing conventional electrophoretic displays, or those skilled in the art of microencapsulation. The combination of these materials and processes, along with the other necessary components found in an encapsulated electrophoretic display, comprise the invention described herein.

### A. Particles

There is much flexibility in the choice of particles for use in electrophoretic displays, as described above. For purposes of this invention, a particle is any component that is charged or capable of acquiring a charge (*i.e*., has or is capable of acquiring electrophoretic mobility), and, in some cases, this mobility may be zero or close to zero (*i.e*., the particles will not move). The particles may be neat pigments, dyed (laked) pigments or pigment/polymer composites, or any other component that is charged or capable of acquiring a charge. Typical considerations for the electrophoretic particle are its optical properties, electrical properties, and surface chemistry. The particles may be organic or inorganic compounds, and they may either absorb light or scatter light. The particles for use in the invention may further include scattering pigments, absorbing pigments and luminescent particles. The particles may be retroreflective, such as corner cubes, or they may be electroluminescent, such as zinc sulfide particles, which emit light when excited by an AC field, or they may be photoluminescent. Finally, the particles may be surface treated so as to improve charging or interaction with a charging agent, or to improve dispersibility.

A preferred particle for use in electrophoretic displays of the invention is Titania. The titania particles may be coated with a metal oxide, such as aluminum oxide or silicon oxide, for example. The titania particles may have one, two, or more layers of metal-oxide coating. For example, a titania particle for use in electrophoretic displays of the invention may have a coating of aluminum oxide and a coating of silicon oxide. The coatings may be added to the particle in any order.

The electrophoretic particle is usually a pigment, a polymer, a laked pigment, or some combination of the above. A neat pigment can be any pigment, and, usually for a light colored particle, pigments such as, for example, rutile (titania), anatase (titania), barium sulfate, kaolin, or zinc oxide are useful. Some typical particles have high refractive indicies, high scattering coefficients, and low absorption coefficients. Other particles are absorptive, such as carbon black or colored pigments used in paints and inks. The pigment should also be insoluble in the suspending fluid. Yellow pigments such as diarylide yellow, hansa yellow, and benzidin yellow have also found use in similar displays. Any other reflective material can be employed for a light colored particle, including non-pigment materials, such as metallic particles.

Useful neat pigments include, but are not limited to, PbCrO₄, Cyan blue GT 55-3295 (American Cyanamid Company, Wayne, NJ), Cibacron Black BG (Ciba Company, Inc., Newport, DE), Cibacron Turquoise Blue G (Ciba), Cibalon Black BGL (Ciba), Orasol Black BRG (Ciba), Orasol Black RBL (Ciba), Acetamine Blac, CBS (E. I. du Pont de Nemours and Company, Inc., Wilmington, DE), Crocein Scarlet N Ex (du Pont) (27290), Fiber Black VF (duPont) (30235), Luxol Fast Black L (duPont) (Solv. Black 17), Nirosine Base No. 424 (duPont) (50415 B), Oil Black BG (duPont) (Solv. Black 16), Rotalin Black RM (duPont), Sevron Brilliant Red 3 B (duPont); Basic Black DSC (Dye Specialties, Inc.), Hectolene Black (Dye Specialties, Inc.), Azosol Brilliant Blue B (GAF, Dyestuff and Chemical Division, Wayne, NJ) (Solv. Blue 9), Azosol Brilliant Green BA (GAF) (Solv. Green 2), Azosol Fast Brilliant Red B (GAF), Azosol Fast Orange RA Conc. (GAF) (Solv. Orange 20), Azosol Fast Yellow GRA Conc. (GAF) (13900 A), Basic Black KMPA (GAF), Benzofix Black CW-CF (GAF) (35435), Cellitazol BNFV Ex Soluble CF (GAF) (Disp. Black 9), Celliton Fast Blue AF Ex Conc (GAF) (Disp. Blue 9), Cyper Black IA (GAF) (Basic Blk. 3), Diamine Black CAP Ex Conc (GAF) (30235), Diamond Black EAN Hi Con. CF (GAF) (15710), Diamond Black PBBA Ex (GAF) (16505); Direct Deep Black EA Ex CF (GAF) (30235), Hansa Yellow G (GAF) (11680); Indanthrene Black BBK Powd. (GAF) (59850), Indocarbon CLGS Conc. CF (GAF) (53295), Katigen Deep Black NND Hi Conc. CF (GAF) (15711), Rapidogen Black 3 G (GAF) (Azoic Blk. 4); Sulphone Cyanine Black BA-CF (GAF) (26370), Zambezi Black VD Ex Conc. (GAF) (30015); Rubanox Red CP-1495 (The Sherwin-Williams Company, Cleveland, OH) (15630); Raven 11 (Columbian Carbon Company, Atlanta, GA), (carbon black aggregates with a particle size of about 25 µm), Statex B-12 (Columbian Carbon Co.) (a furnace black of 33 µm average particle size), and chrome green.

Particles may also include laked, or dyed, pigments. Laked pigments are particles that have a dye precipitated on them or which are stained. Lakes are metal salts of readily soluble anionic dyes. These are dyes of azo, triphenylmethane or anthraquinone structure containing one or more sulphonic or carboxylic acid groupings. They are usually precipitated by a calcium, barium or aluminum salt onto a substrate. Typical examples are peacock blue lake (CI Pigment Blue 24) and Persian orange (lake of CI Acid Orange 7), Black M Toner (GAF) (a mixture of carbon black and black dye precipitated on a lake).

A dark particle of the dyed type may be constructed from any light absorbing material, such as carbon black, or inorganic black materials. The dark material may also be selectively absorbing. For example, a dark green pigment may be used. Black particles may also be formed by staining latices with metal oxides, such latex copolymers consisting of any of butadiene, styrene, isoprene, methacrylic acid, methyl methacrylate, acrylonitrile, vinyl chloride, acrylic acid, sodium styrene sulfonate, vinyl acetate, chlorostyrene, dimethylaminopropylmethacrylamide, isocyanoethyl methacrylate and N-(isobutoxymethacrylamide), and optionally including conjugated diene compounds such as diacrylate, triacrylate, dimethylacrylate and trimethacrylate. Black particles may also be formed by a dispersion polymerization technique.

In the systems containing pigments and polymers, the pigments and polymers may form multiple domains within the electrophoretic particle, or be aggregates of smaller pigment/polymer combined particles. Alternatively, a central pigment core may be surrounded by a polymer shell. The pigment, polymer, or both can contain a dye. The optical purpose of the particle may be to scatter light, absorb light, or both. Useful sizes may range from 1 nm up to about 100 µm, as long as the particles are smaller than the bounding capsule. In a preferred embodiment, the density of the electrophoretic particle may be substantially matched to that of the suspending (*i.e*., electrophoretic) fluid. As defined herein, a suspending fluid has a density that is "substantially matched" to the density of the particle if the difference in their respective densities is between about zero and about two g/ml. This difference is preferably between about zero and about 0.5 g/ml.

Useful polymers for the particles include, but are not limited to: polystyrene, polyethylene, polypropylene, phenolic resins, Du Pont Elvax resins (ethylene-vinyl acetate copolymers), polyesters, polyacrylates, polymethacrylates, ethylene acrylic acid or methacrylic acid copolymers (Nucrel Resins - Dupont, Primacor Resins- Dow Chemical), acrylic copolymers and terpolymers (Elvacite Resins, DuPont) and PMMA. Useful materials for homopolymer / pigment phase separation in high shear melt include, but are not limited to, polyethylene, polypropylene, polymethylmethacrylate, polyisobutylmethacrylate, polystyrene, polybutadiene, polyisoprene, polyisobutylene, polylauryl methacrylate, polystearyl methacrylate, polyisobornyl methacrylate, poly-t-butyl methacrylate, polyethyl methacrylate, polymethyl acrylate, polyethyl acrylate, polyacrylonitrile, and copolymers of two or more of these materials. Some useful pigment/polymer complexes that are commercially available include, but are not limited to, Process Magenta PM 1776 (Magruder Color Company, Inc., Elizabeth, NJ), Methyl Violet PMA VM6223 (Magruder Color Company, Inc., Elizabeth, NJ), and Naphthol FGR RF6257 (Magruder Color Company, Inc., Elizabeth, NJ).

The pigment-polymer composite may be formed by a physical process, (*e.g*., attrition or ball milling), a chemical process (*e.g*., microencapsulation or dispersion polymerization), or any other process known in the art of particle production. From the following non-limiting examples, it may be seen that the processes and materials for both the fabrication of particles and the charging thereof are generally derived from the art of liquid toner, or liquid immersion development. Thus any of the known processes from liquid development are particularly, but not exclusively, relevant.

New and useful electrophoretic particles may still be discovered, but a number of particles already known to those skilled in the art of electrophoretic displays and liquid toners can also prove useful. In general, the polymer requirements for liquid toners and encapsulated electrophoretic inks are similar, in that the pigment or dye must be easily incorporated therein, either by a physical, chemical, or physicochemical process, may aid in the colloidal stability, and may contain charging sites or may be able to incorporate materials which contain charging sites. One general requirement from the liquid toner industry that is not shared by encapsulated electrophoretic inks is that the toner must be capable of "fixing" the image, *i.e*., heat fusing together to create a uniform film after the deposition of the toner particles.

Typical manufacturing techniques for particles are drawn from the liquid toner and other arts and include ball milling, attrition, jet milling, *etc.* The process will be illustrated for the case of a pigmented polymeric particle. In such a case the pigment is compounded in the polymer, usually in some kind of high shear mechanism such as a screw extruder. The composite material is then (wet or dry) ground to a starting size of around 10 µm. It is then dispersed in a carrier liquid, for example ISOPAR® (Exxon, Houston, TX), optionally with some charge control agent(s), and milled under high shear for several hours down to a final particle size and/or size distribution.

Another manufacturing technique for particles drawn from the liquid toner field is to add the polymer, pigment, and suspending fluid to a media mill. The mill is started and simultaneously heated to temperature at which the polymer swells substantially with the solvent. This temperature is typically near 100°C. In this state, the pigment is easily encapsulated into the swollen polymer. After a suitable time, typically a few hours, the mill is gradually cooled back to ambient temperature while stirring. The milling may be continued for some time to achieve a small enough particle size, typically a few microns in diameter. The charging agents may be added at this time. Optionally, more suspending fluid may be added.

Chemical processes such as dispersion polymerization, mini- or micro-emulsion polymerization, suspension polymerization precipitation, phase separation, solvent evaporation, *in situ* polymerization, seeded emulsion polymerization, or any process which falls under the general category of microencapsulation may be used. A typical process of this type is a phase separation process wherein a dissolved polymeric material is precipitated out of solution onto a dispersed pigment surface through solvent dilution, evaporation, or a thermal change. Other processes include chemical means for staining polymeric latices, for example with metal oxides or dyes.

### B. Suspending Fluid

The suspending fluid containing the particles can be chosen based on properties such as density, refractive index, and solubility. A preferred suspending fluid has a low dielectric constant (about 2), high volume resistivity (about 10^15 ohm-cm), low viscosity (less than 5 cst), low toxicity and environmental impact, low water solubility (less than 10 ppm), high specific gravity (greater than 1.5), a high boiling point (greater than 90°C), and a low refractive index (less than 1.2).

The choice of suspending fluid may be based on concerns of chemical inertness, density matching to the electrophoretic particle, or chemical compatibility with both the electrophoretic particle and bounding capsule. The viscosity of the fluid should be low when you want the particles to move. The refractive index of the suspending fluid may also be substantially matched to that of the particles. As used herein, the refractive index of a suspending fluid "is substantially matched" to that of a particle if the difference between their respective refractive indices is between about zero and about 0.3, and is preferably between about 0.05 and about 0.2.

Additionally, the fluid may be chosen to be a poor solvent for some polymers, which is advantageous for use in the fabrication of microparticles because it increases the range of polymeric materials useful in fabricating particles of polymers and pigments. Organic solvents, such as halogenated organic solvents, saturated linear or branched hydrocarbons, silicone oils, and low molecular weight halogen-containing polymers are some useful suspending fluids. The suspending fluid may comprise a single fluid. The fluid will, however, often be a blend of more than one fluid in order to tune its chemical and physical properties. Furthermore, the fluid may contain surface modifiers to modify the surface energy or charge of the electrophoretic particle or bounding capsule. Reactants or solvents for the microencapsulation process (oil soluble monomers, for example) can also be contained in the suspending fluid. Charge control agents can also be added to the suspending fluid.

Useful organic solvents include, but are not limited to, epoxides, such as, for example, decane epoxide and dodecane epoxide; vinyl ethers, such as, for example, cyclohexyl vinyl ether and Decave® (International Flavors & Fragrances, Inc., New York, NY); and aromatic hydrocarbons, such as, for example, toluene and naphthalene. Useful halogenated organic solvents include, but are not limited to, tetrafluorodibromoethylene, tetrachloroethylene, trifluorochloroethylene, 1,2,4-trichlorobenzene, carbon tetrachloride. These materials have high densities. Useful hydrocarbons include, but are not limited to, dodecane, tetradecane, the aliphatic hydrocarbons in the Isopar® series (Exxon, Houston, TX), Norpar® ( series of normal paraffinic liquids), Shell-Sol® (Shell, Houston, TX), and Sol-Trol® (Shell), naphtha, and other petroleum solvents. These materials usually have low densities. Useful examples of silicone oils include, but are not limited to, octamethyl cyclosiloxane and higher molecular weight cyclic siloxanes, poly (methyl phenyl siloxane), hexamethyldisiloxane, and polydimethylsiloxane. These materials usually have low densities. Useful low molecular weight halogen-containing polymers include, but are not limited to, poly(chlorotrifluoroethylene) polymer (Halogenated hydrocarbon Inc., River Edge, NJ), Galden® (a perfluorinated ether from Ausimont, Morristown, NJ), or Krytox® from Dupont (Wilmington, DE). In a preferred embodiment, the suspending fluid is a poly(chlorotrifluoroethylene) polymer. In a particularly preferred embodiment, this polymer has a degree of polymerization from about 2 to about 10. Many of the above materials are available in a range of viscosities, densities, and boiling points.

The fluid must be capable of being formed into small droplets prior to a capsule being formed. Processes for forming small droplets include flow-through jets, membranes, nozzles, or orifices, as well as shear-based emulsifying schemes. The formation of small drops may be assisted by electrical or sonic fields. Surfactants and polymers can be used to aid in the stabilization and emulsification of the droplets in the case of an emulsion type encapsulation. A preferred surfactant for use in displays of the invention is sodium dodecylsulfate.

It can be advantageous in some displays for the suspending fluid to contain an optically absorbing dye. This dye must be soluble in the fluid, but will generally be insoluble in the other components of the capsule. There is much flexibility in the choice of dye material. The dye can be a pure compound, or blends of dyes to achieve a particular color, including black. The dyes can be fluorescent, which would produce a display in which the fluorescence properties depend on the position of the particles. The dyes can be photoactive, changing to another color or becoming colorless upon irradiation with either visible or ultraviolet light, providing another means for obtaining an optical response. Dyes could also be polymerizable, forming a solid absorbing polymer inside the bounding shell.

There are many dyes that can be chosen for use in encapsulated electrophoretic display. Properties important here include light fastness, solubility in the suspending liquid, color, and cost. These are generally from the class of azo, anthraquinone, and triphenylmethane type dyes and may be chemically modified so as to increase the solubility in the oil phase and reduce the adsorption by the particle surface.

A number of dyes already known to those skilled in the art of electrophoretic displays will prove useful. Useful azo dyes include, but are not limited to: the Oil Red dyes, and the Sudan Red and Sudan Black series of dyes. Useful anthraquinone dyes include, but are not limited to: the Oil Blue dyes, and the Macrolex Blue series of dyes. Useful triphenylmethane dyes include, but are not limited to, Michler's hydrol, Malachite Green, Crystal Violet, and Auramine O.

### C. Charge Control Agents and Particle Stabilizers

Charge control agents are used to provide good electrophoretic mobility to the electrophoretic particles. Stabilizers are used to prevent agglomeration of the electrophoretic particles, as well as prevent the electrophoretic particles from irreversibly depositing onto the capsule wall. Either component can be constructed from materials across a wide range of molecular weights (low molecular weight, oligomeric, or polymeric), and may be pure or a mixture. In particular, suitable charge control agents are generally adapted from the liquid toner art. The charge control agent used to modify and/or stabilize the particle surface charge is applied as generally known in the arts of liquid toners, electrophoretic displays, non-aqueous paint dispersions, and engine-oil additives. In all of these arts, charging species may be added to non-aqueous media in order to increase electrophoretic mobility or increase electrostatic stabilization. The materials can improve steric stabilization as well. Different theories of charging are postulated, including selective ion adsorption, proton transfer, and contact electrification.

An optional charge control agent or charge director may be used. These constituents typically consist of low molecular weight surfactants, polymeric agents, or blends of one or more components and serve to stabilize or otherwise modify the sign and/or magnitude of the charge on the electrophoretic particles. The charging properties of the pigment itself may be accounted for by taking into account the acidic or basic surface properties of the pigment, or the charging sites may take place on the carrier resin surface (if present), or a combination of the two. Additional pigment properties which may be relevant are the particle size distribution, the chemical composition, and the lightfastness. The charge control agent used to modify and/or stabilize the particle surface charge is applied as generally known in the arts of liquid toners, electrophoretic displays, non-aqueous paint dispersions, and engine-oil additives. In all of these arts, charging species may be added to non-aqueous media in order to increase electrophoretic mobility or increase electrostatic stabilization. The materials can improve steric stabilization as well. Different theories of charging are postulated, including selective ion adsorption, proton transfer, and contact electrification.

Charge adjuvents may also be added. These materials increase the effectiveness of the charge control agents or charge directors. The charge adjuvent may be a polyhydroxy compound or an aminoalcohol compound, which are preferably soluble in the suspending fluid in an amount of at least 2% by weight. Examples of polyhydroxy compounds which contain at least two hydroxyl groups include, but are not limited to, ethylene glycol, 2,4,7,9-tetramethyl-decyn-4,7-diol, poly (propylene glycol), pentaethylene glycol, tripropylene glycol, triethylene glycol, glycerol, pentaerythritol, glycerol-tri-12 hydroxystearate, propylene glycerol monohydroxystearate, and ethylene glycol monohydroxystrearate. Examples of aminoalcohol compounds which contain at least one alcohol function and one amine function in the same molecule include, but are not limited to, triisopropanolamine, triethanolamine, ethanolamine, 3-amino-1 propanol, o-aminophenol, 5-amino-1-pentanol, and tetra(2-hydroxyehtyl)ethylene-diamine. The charge adjuvent is preferably present in the suspending fluid in an amount of about 1 to about 100 mg/g of the particle mass, and more preferably about 50 to about 200 mg/g.

The surface of the particle may also be chemically modified to aid dispersion, to improve surface charge, and to improve the stability of the dispersion, for example. Surface modifiers include organic siloxanes, organohalogen silanes and other functional silane coupling agents (Dow Corning® Z-6070, Z-6124, and 3 additive, Midland, MI); organic titanates and zirconates (Tyzor® TOT, TBT, and TE Series, Dupont, Wilmington, DE); hydrophobing agents, such as long chain (C12 to C50) alkyl and alkyl benzene sulphonic acids, fatty amines or diamines and their salts or quarternary derivatives; and amphipathic polymers which can be covalently bonded to the particle surface.

In general, it is believed that charging results as an acid-base reaction between some moiety present in the continuous phase and the particle surface. Thus useful materials are those which are capable of participating in such a reaction, or any other charging reaction as known in the art.

Different non-limiting classes of charge control agents which are useful include organic sulfates or sulfonates, metal soaps, block or comb copolymers, organic amides, organic zwitterions, and organic phosphates and phosphonates. Useful organic sulfates and sulfonates include, but are not limited to, bis(2-ethyl hexyl) sodium sulfosuccinate, calcium dodecyl benzene sulfonate, calcium petroleum sulfonate, neutral or basic barium dinonylnaphthalene sulfonate, neutral or basic calcium dinonylnaphthalene sulfonate, dodecylbenzenesulfonic acid sodium salt, and ammonium lauryl sulphate. Useful metal soaps include, but are not limited to, basic or neutral barium petronate, calcium petronate, Co-, Ca-, Cu-, Mn-, Ni-, Zn-, and Fe- salts of naphthenic acid, Ba-, Al-, Zn-, Cu-, Pb-, and Fe- salts of stearic acid, divalent and trivalent metal carboxylates, such as aluminum tristearate, aluminum octoate, lithium heptanoate, iron stearate, iron distearate, barium stearate, chromium stearate, magnesium octoate, calcium stearate, iron naphthenate, and zinc naphthenate, Mn- and Zn- heptanoate, and Ba-, Al-, Co-, Mn-, and Zn- Octoate. Useful block or comb copolymers include, but are not limited to, AB diblock copolymers of (A) polymers of 2-(N,N) dimethylaminoethyl methacrylate quaternized with methyl-p-toluenesulfonate and (B) poly-2-ethylhexyl methacrylate, and comb graft copolymers with oil soluble tails of poly (12-hydroxystearic acid) and having a molecular weight of about 1800, pendant on an oil-soluble anchor group of poly (methyl methacrylate-methacrylic acid). Useful organic amides include, but are not limited to, polyisobutylene succinimides such as OLOA 1200, and N-vinyl pyrrolidone polymers. Useful organic zwitterions include, but are not limited to, lecithin. Useful organic phosphates and phosphonates include, but are not limited to, the sodium salts of phosphated mono- and di-glycerides with saturated and unsaturated acid substituents.

Particle dispersion stabilizers may be added to prevent particle flocculation or attachment to the capsule walls. For the typical high resistivity liquids used as suspending fluids in electrophoretic displays, nonaqueous surfactants may be used. These include, but are not limited to, glycol ethers, acetylenic glycols, alkanolamides, sorbitol derivatives, alkyl amines, quaternary amines, imidazolines, dialkyl oxides, and sulfosuccinates.

### D. Encapsulation

There is a long and rich history to encapsulation, with numerous processes and polymers having proven useful in creating capsules. Encapsulation of the internal phase may be accomplished in a number of different ways. Numerous suitable procedures for microencapsulation are detailed in both *Microencapsulation, Processes and Applications*, (I. E. Vandegaer, ed.), Plenum Press, New York, NY (1974) and Gutcho, *Microcapsules and Mircroencapsulation Techniques,* Nuyes Data Corp., Park Ridge, N.J. (1976). The processes fall into several general categories, all of which can be applied to the present invention: interfacial polymerization, *in situ* polymerization, physical processes, such as coextrusion and other phase separation processes, in-liquid curing, and simple/complex coacervation.

Numerous materials and processes should prove useful in formulating displays of the present invention. Useful materials for simple coacervation processes include, but are not limited to, gelatin, polyvinyl alcohol, polyvinyl acetate, and cellulosic derivatives, such as, for example, carboxymethylcellulose. Useful materials for complex coacervation processes include, but are not limited to, gelatin, acacia, carageenan, carboxymethylcellulose, hydrolized styrene anhydride copolymers, agar, alginate, casein, albumin, methyl vinyl ether co-maleic anhydride, and cellulose phthalate. Useful materials for phase separation processes include, but are not limited to, polystyrene, PMMA, polyethyl methacrylate, polybutyl methacrylate, ethyl cellulose, polyvinyl pyridine, and poly acrylonitrile. Useful materials for *in situ* polymerization processes include, but are not limited to, polyhydroxyamides, with aldehydes, melamine, or urea and formaldehyde; water-soluble oligomers of the condensate of melamine, or urea and formaldehyde; and vinyl monomers, such as, for example, styrene, MMA and acrylonitrile. Finally, useful materials for interfacial polymerization processes include, but are not limited to, diacyl chlorides, such as, for example, sebacoyl, adipoyl, and di- or poly- amines or alcohols, and isocyanates. Useful emulsion polymerization materials may include, but are not limited to, styrene, vinyl acetate, acrylic acid, butyl acrylate, t-butyl acrylate, methyl methacrylate, and butyl methacrylate.

Capsules produced may be dispersed into a curable carrier, resulting in an ink which may be printed or coated on large and arbitrarily shaped or curved surfaces using conventional printing and coating techniques.

In the context of the present invention, one skilled in the art will select an encapsulation procedure and wall material based on the desired capsule properties. These properties include the distribution of capsule radii; electrical, mechanical, diffusion, and optical properties of the capsule wall; and chemical compatibility with the internal phase of the capsule.

The capsule wall generally has a high electrical resistivity. Although it is possible to use walls with relatively low resistivities, this may limit performance in requiring relatively higher addressing voltages. The capsule wall should also be mechanically strong (although if the finished capsule powder is to be dispersed in a curable polymeric binder for coating, mechanical strength is not as critical). The capsule wall should generally not be porous. If, however, it is desired to use an encapsulation procedure that produces porous capsules, these can be overcoated in a post-processing step (*i.e.,* a second encapsulation). Moreover, if the capsules are to be dispersed in a curable binder, the binder will serve to close the pores. The capsule walls should be optically clear. The wall material may, however, be chosen to match the refractive index of the internal phase of the capsule (*i.e*., the suspending fluid) or a binder in which the capsules are to be dispersed. For some applications (*e.g*., interposition between two fixed electrodes), monodispersed capsule radii are desirable.

An encapsulation procedure involves a polymerization between urea and formaldehyde in an aqueous phase of an oil/water emulsion in the presence of a negatively charged, carboxyl-substituted, linear hydrocarbon polyelectrolyte material. The resulting capsule wall is a urea/formaldehyde copolymer, which discretely encloses the internal phase. The capsule is clear, mechanically strong, and has good resistivity properties.

The related technique of *in situ* polymerization utilizes an oil/Water emulsion, which is formed by dispersing the electrophoretic composition (*i.e*., the dielectric liquid containing a suspension of the pigment particles) in an aqueous environment. The monomers polymerize to form a polymer with higher affinity for the internal phase than for the aqueous phase, thus condensing around the emulsified oily droplets. In one especially useful *in situ* polymerization processes, urea and formaldehyde condense in the presence of poly(acrylic acid) (See, *e.g*., US-A-4 001 140. In other useful process, any of a variety of cross-linking agents borne in aqueous solution is deposited around microscopic oil droplets. Such cross-linking agents include aldehydes, especially formaldehyde, glyoxal, or glutaraldehyde; alum; zirconium salts; and poly isocyanates.

The coacervation approach also utilizes an oil/water emulsion. One or more colloids are coacervated (*i.e*., agglomerated) out of the aqueous phase and deposited as shells around the oily droplets through control of temperature, pH and/or relative concentrations, thereby creating the microcapsule. Materials suitable for coacervation include gelatins and gum arabic.

The interfacial polymerization approach relies on the presence of an oil-soluble monomer in the electrophoretic composition, which once again is present as an emulsion in an aqueous phase. The monomers in the minute hydrophobic droplets react with a monomer introduced into the aqueous phase, polymerizing at the interface between the droplets and the surrounding aqueous medium and forming shells around the droplets. Although the resulting walls are relatively thin and may be permeable, this process does not require the elevated temperatures characteristic of some other processes, and therefore affords greater flexibility in terms of choosing the dielectric liquid.

Coating aids can be used to improve the uniformity and quality of the coated or printed electrophoretic ink material. Wetting agents are typically added to adjust the interfacial tension at the coating/substrate interface and to adjust the liquid/air surface tension. Wetting agents include, but are not limited to, anionic and cationic surfactants, and nonionic species, such as silicone or fluoropolymer based materials. Dispersing agents may be used to modify the interfacial tension between the capsules and binder, providing control over flocculation and particle settling.

Surface tension modifiers can be added to adjust the air/ink interfacial tension. Polysiloxanes are typically used in such an application to improve surface leveling while minimizing other defects within the coating. Surface tension modifiers include, but are not limited to, fluorinated surfactants, such as, for example, the Zonyl® series from DuPont (Wilmington, DE), the Fluorod® series from 3M (St. Paul, MN), and the fluoroakyl series from Autochem (Glen Rock, NJ); siloxanes, such as, for example, Silwet® from Union Carbide (Danbury, CT); and polyethoxy and polypropoxy alcohols. Antifoams, such as silicone and silicone-free polymeric materials, may be added to enhance the movement of air from within the ink to the surface and to facilitate the rupture of bubbles at the coating surface. Other useful antifoams include, but are not limited to, glyceryl esters, polyhydric alcohols, compounded antifoams, such as oil solutions of alkyl benzenes, natural fats, fatty acids, and metallic soaps, and silicone antifoaming agents made from the combination of dimethyl siloxane polymers and silica. Stabilizers such as uv-absorbers and antioxidants may also be added to improve the lifetime of the ink.

Other additives to control properties like coating viscosity and foaming can also be used in the coating fluid. Stabilizers (uv-absorbers, antioxidants) and other additives which could prove useful in practical materials.

### E. Binder Material

The binder is used as a non-conducting, adhesive medium supporting and protecting the capsules, as well as binding the electrode materials to the capsule dispersion. Binders are available in many forms and chemical types. Among these are water-soluble polymers, water-borne polymers, oil-soluble polymers, thermoset and thermoplastic polymers, and radiation-cured polymers.

Among the water-soluble polymers are the various polysaccharides, the polyvinyl alcohols, N-methyl pyrrolidone, N-vinyl pyrrolidone, the various Carbowax® species (Union Carbide, Danbury, CT), and poly-2-hydroxyethylacrylate.

The water-dispersed or water-borne systems are generally latex compositions, typified by the Neorez® and Neocryl® resins (Zeneca Resins, Wilmington, MA), Acrysol® (Rohm and Haas, Philadelphia, PA), Bayhydrol® (Bayer, Pittsburgh, PA), and the Cytec Industries (West Paterson, NJ) HP line. These are generally latices of polyurethanes, occasionally compounded with one or more of the acrylics, polyesters, polycarbonates or silicones, each lending the final cured resin in a specific set of properties defined by glass transition temperature, degree of "tack," softness, clarity, flexibility, water permeability and solvent resistance, elongation modulus and tensile strength, thermoplastic flow, and solids level. Some water-borne systems can be mixed with reactive monomers and catalyzed to form more complex resins. Some can be further cross-linked by the use of a crosslinking reagent, such as an aziridine, for example, which reacts with carboxyl groups.

A typical application of a water-borne resin and aqueous capsules follows. A volume of particles is centrifuged at low speed to separate excess water. After a given centrifugation process, for example 10 minutes at 60 x G, the capsules are found at the bottom of the centrifuge tube, while the water portion is at the top. The water portion is carefully removed (by decanting or pipetting). The mass of the remaining capsules is measured, and a mass of resin is added such that the mass of resin is between one eighth and one tenth of the weight of the capsules. This mixture is gently mixed on an oscillating mixer for approximately one half hour. After about one half hour, the mixture is ready to be coated onto the appropriate substrate.

The thermoset systems are exemplified by the family of epoxies. These binary systems can vary greatly in viscosity, and the reactivity of the pair determines the "pot life" of the mixture. If the pot life is long enough to allow a coating operation, capsules may be coated in an ordered arrangement in a coating process prior to the resin curing and hardening.

Thermoplastic polymers, which are often polyesters, are molten at high temperatures. A typical application of this type of product is hot-melt glue. A dispersion of heat-resistant capsules could be coated in such a medium. The solidification process begins during cooling, and the final hardness, clarity and flexibility are affected by the branching and molecular weight of the polymer.

Oil or solvent-soluble polymers are often similar in composition to the water-borne system, with the obvious exception of the water itself. The latitude in formulation for solvent systems is enormous, limited only by solvent choices and polymer solubility. Of considerable concern in solvent-based systems is the viability of the capsule itself - the integrity of the capsule wall cannot be compromised in any way by the solvent.

Radiation cure resins are generally found among the solvent-based systems. Capsules may be dispersed in such a medium and coated, and the resin may then be cured by a timed exposure to a threshold level of ultraviolet radiation, either long or short wavelength. As in all cases of curing polymer resins, final properties are determined by the branching and molecular weights of the monomers, oligomers and crosslinkers.

A number of "water-reducible" monomers and oligomers are, however, marketed. In the strictest sense, they are not water soluble, but water is an acceptable diluent at low concentrations and can be dispersed relatively easily in the mixture. Under these circumstances, water is used to reduce the viscosity (initially from thousands to hundreds of thousands centipoise). Water-based capsules, such as those made from a protein or polysaccharide material, for example, could be dispersed in such a medium and coated, provided the viscosity could be sufficiently lowered. Curing in such systems is generally by ultraviolet radiation.

For illustration purpose, Figure 7 shows only one non-linear circuit element. However, multiple non-linear circuit elements, and other circuitry such as logic or driver circuitry can be fabricated on the silicon wafer as substantially described above and transferred to the display using the lift-off process. In addition, the lift-off process described with reference to Figure 7 is exemplary only. Other variations of the lift-off process can be used in accordance with the present invention. For example, a laterally grown epitaxial film can be cleaved rather than chemically etched for separation.

In one embodiment, the lift-off process is used to transfer the non-linear elements to a flexible substrate such as insulated metal foil, paper, or woven material (e.g., cloth) instead of an optically transparent material. Alternatively, the lift-off process is used to transfer the non-linear elements to a composite material or a layered substrate. Examples of these materials include particle-filled plastics and polymer/glass laminants. In another embodiment, the non-linear elements can be fabricated on a substrate other than a silicon wafer, which is capable of withstanding high temperature processing steps. Examples of such substrates include, but are not limited to, glass and metal foils. These materials are less costly than silicon wafers, and could prove beneficial in manufacturing low cost devices.

In another embodiment, the non-linear elements and the electrodes are first fabricated on a substrate such as a silicon wafer and the encapsulated display medium is placed adjacent the non-linear elements. In this embodiment, a separate substrate for the display medium is not necessary.

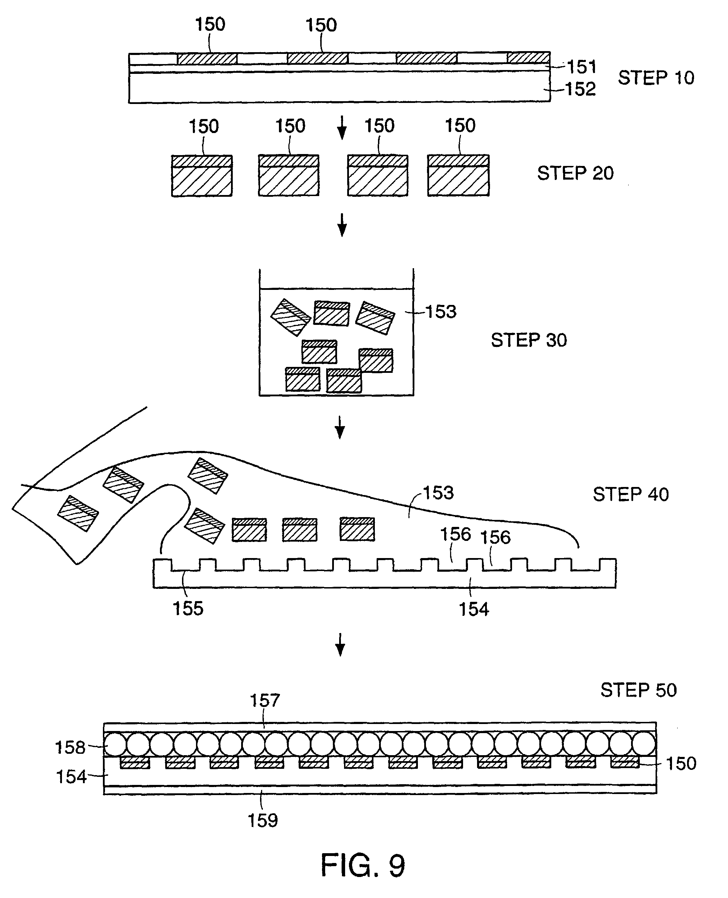

In another embodiment, an electronic display is fabricated according to a fluidic transport process illustrated in Figure 9. Referring to Figure 9, a plurality of non-linear circuit elements 150 such as transistors are formed on a silicon wafer 152. Subsequently, the non-linear circuit elements 150 are separated from each other. In the embodiment of Figure 9, the non-linear circuit elements 150 are fabricated over a sacrificial layer 151, which is etched away to separate the non-linear circuit elements 150 from each other and from the wafer 152 (steps 10 and 20). The separated non-linear circuit elements 150 are placed in a solution to form a slurry 153 (step 30). While many liquid carriers are feasible, water, optionally containing surfactants, is one example of a suitable liquid carrier.

A substrate 154 comprising a plurality of impressions 156 is provided. The substrate 154 can comprise a transparent material such as glass or plastic. Alternatively, the substrate 154 can comprise other non-conductive material. In one embodiment, a conductive pixel 155 is provided adjacent each impression 156. The substrate 154 can also comprise sufficient conductive traces to connect the fluid-deposited nonlinear circuit elements 150 to the appropriate control circuitry. In one example, where diodes are used as the nonlinear circuit elements 150, the impressions 156 are coupled together by row electrodes to form linear arrays of diodes and pixels. Once the diodes are deposited, electrical connection is made between the nonlinear circuit elements 150 and the pixel electrodes and the row electrodes. In one embodiment, this connection happens automatically, where the impression is in electrical contact with the pixel and row electrodes, such that when a diode is placed in the impression 156, the diode forms an electrical connection with the impression 156, and so becomes electrically connected to a pixel and a row electrode. Alternatively, a secondary processing step could be used to deposit a conductor onto the non-linear circuit element 150, making these electrode connections. This secondary step could be performed using any suitable process such as vacuum evaporation or printing.

While the previous example listed diodes as the nonlinear circuit elements, it is also possible to use transistors or other nonlinear elements as previously described. In the embodiment in which the transistors are used, conductive traces connecting the gate electrodes to each transistor, as well as connection between the pixel electrode and the transistor drain can be made. As before, these connections could happen automatically after implantation, or could be assisted by a subsequent evaporation or printing of conductive materials.

Each impression 156 is sized and shaped to receive a non-linear circuit element 150 in the proper orientation. The impressions 156 can be made by various means, including etching, embossing, or stamping. The slurry 153 comprising the non-linear circuit elements 50 is poured over the substrate 154 and the substrate 154 is agitated (step 40). Agitation of the substrate 154 allows the non-linear circuit elements 150 to fall into the impressions 156 in the right orientation. The non-linear circuit elements 150 can be bonded to the substrate 154 by various means, including pressure, adhesives, or other coatings. An encapsulated display medium 158 is positioned over the substrate 154 comprising the nonlinear circuit elements 150 (step 50). The encapsulated display medium 158 can be pre-fabricated on a separate substrate as described above. An adhesive layer is used between the display and nonlinear circuit elements. This adhesive layer serves to stabilize the nonlinear circuit elements, to prevent the nonlinear circuit elements from popping out of their impression. Additionally, the solid nature of the microencapsulated display medium can also serve to keep the nonlinear circuit elements in their place. Alternatively, the encapsulated display medium can be printed directly over the substrate 154. A pair of electrodes 157, 159 are positioned adjacent the encapsulated display medium 158 and the substrate 154 to address the encapsulated display medium 158.

The above described processes can also be used to prepare logic or drive circuitry for use with an electronic display. For example, addressing circuitry for electronic displays can be fabricated using this method, with a differently sized nonlinear circuit element. For example, these addressing circuit elements could be larger in size than the nonlinear display elements, and elongated in shape. A first deposition process could be used to deposit these circuit addressing elements into impressions sized and shaped to receive these elements, along the periphery of the display; the impressions for the nonlinear circuit elements would be too small to receive these addressing circuit elements. A second deposition step could then be used deposit the nonlinear display circuit elements.

Alternatively, it is possible to combine elements of the lift-off and fluidic transport processes. For example, addressing circuitry could be constructed and deposited using the lift-off and transfer process described previously, while the individual nonlinear display elements could be subsequently deposited using the fluidic transport method. Other combinations of these schemes are obvious.

## Claims

1. A method of forming a display (132), the method comprising:
(a) providing a first substrate (123, 124b) having a release layer (124a) disposed thereon;
(b) forming an array of non-linear circuit elements (121) on the release layer (124a);
(c) separating the array of non-linear circuit elements (121) from the first substrate (123; 124b); and
(d) placing the array of non-linear circuit elements (121) on a second substrate,
the method being **characterized by**:
(e) placing the second substrate adjacent a surface of an display medium (112') comprising a plurality of capsules, each capsule comprising a plurality of particles dispersed in a fluid, with an adhesive layer (141) being interposed between said second substrate and said surface of said display medium (112').

2. A method according to claim 1 **characterized in that** the display medium is an electrophoretic display medium.

3. A method according to either of the preceding claims **characterized in that** the non-linear circuit elements are thin-film transistors, thin-film diodes, metal-insulator-metal diodes, back-to-back diodes, or diode rings.

4. A method any one of the preceding claims **characterized in that** step (c) comprises lifting off the plurality of non-linear circuit elements.

5. A method according to any one of claims 1 to 3 **characterized in that** step (d) comprises bonding the non-linear circuit elements to the second substrate.

6. A method any one of the preceding claims **characterized in that** step (d) comprises placing the non-linear circuit elements on a glass or plastic substrate, a metal foil, a paper, or a flexible substrate.

7. A method any one of the preceding claims **characterized in that** step (b) comprises forming the non-linear circuit elements on a silicon wafer.

8. A method of forming a display, the method comprising:
(a) providing a plurality of non-linear circuit elements (150);
(b) placing the plurality of non-linear circuit elements (150) in a slurry (153) to form a mixture;
(c) providing a substrate (154) comprising a plurality of impressions (156);
(d) placing the mixture on the substrate (154); and
(e) agitating the substrate (154) such that the plurality of non-linear circuit elements (150) fall in the plurality of impressions (156) to form an array of non-linear circuit elements;
the method being **characterized by**:
(f) placing the substrate (154) on a surface of an display medium (158) comprising a plurality of capsules, each capsule comprising a plurality of particles dispersed in a fluid, with an adhesive layer being interposed between said substrate (154) and said surface of said display medium (158).

9. A method according to claim 8 **characterized in that** the display medium is an electrophoretic display medium.

10. A method according to claim 8 or 9 **characterized in that** the non-linear circuit elements comprise thin-film silicon transistors, or thin-film diodes.

11. A method according to any one of claims 8 to 10 **characterized in that** step (c) comprises forming the plurality of impressions and forming conductive traces and a pixel electrode in each impression.

12. A method according to any one of claims 8 to 11 **characterized in that** step (a) comprises providing a first substrate, forming the non-linear circuit elements on the first substrate, and separating the non-linear circuit elements from the first substrate; and step (c) comprises providing a second substrate.

13. A method according to claim 12 **characterized in that** the first substrate comprises a sacrificial layer which is etched to separate the non-linear circuit elements.

## Patentansprüche

1. Verfahren zur Herstellung einer Anzeige (132) mit den folgenden Schritten:
(a) es wird ein Substrat (123, 124b) bereit gestellt, auf dem eine Trennschicht (124a) angeordnet ist;
(b) es wird ein Feld nicht-linearer Schaltungselemente (121) auf der Trennschicht (124a) ausgebildet;
(c) es wird das Feld nicht-linearer Schaltungselemente (121) von dem ersten Substrat (123; 124b) getrennt; und
(d) es wird das Feld nicht-linearer Schaltungselemente (121) auf einem zweiten Substrat aufgebracht,
wobei das Verfahren **dadurch gekennzeichnet ist, dass**
(e) das zweite Substrat benachbart zu einer Oberfläche eines Anzeigemediums (112') angebracht wird, das eine Vielzahl von Kapseln aufweist und jede Kapsel eine Vielzahl von Partikeln enthält, die in Flüssigkeit dispergiert sind, wobei eine Klebeschicht (141) zwischen das zweite Substrat und die Oberfläche des Anzeigemediums (112') gefügt wird.

2. Verfahren nach Anspruch 1,
**dadurch gekennzeichnet, dass** das Anzeigemedium ein elektrophoretisches Anzeigemedium ist.

3. Verfahren nach einem der vorhergehenden Ansprüche,
**dadurch gekennzeichnet, dass** die nicht-linearen Schaltungselemente DünnschichtTransistoren, Dünnschicht-Dioden, Metall-Isolator-Metall-Dioden, Rücken-an-Rücken-Dioden oder Diodenringe sind.

4. Verfahren nach einem der vorhergehenden Ansprüche,
**dadurch gekennzeichnet, dass** der Schritt (c) ein Abheben der Vielzahl von nicht-linearen Schaltungselementen umfasst.

5. Verfahren nach einem der Ansprüche 1 bis 3,
**dadurch gekennzeichnet, dass** der Schritt (d) eine Verbindung der nicht-linearen Schaltungselemente mit dem zweiten Substrat umfasst.

6. Verfahren nach einem der vorhergehenden Ansprüche,
**dadurch gekennzeichnet, dass** der Schritt (d) das Aufbringen der nicht-linearen Schaltungselemente auf einem Glas oder Plastiksubstrat, einer Metallfolie, einem Papier oder einem flexiblen Substrat umfasst.

7. Verfahren nach einem der vorhergehenden Ansprüche,
**dadurch gekennzeichnet, dass** der Schritt (b) die Anordnung der nicht-linearen Elemente auf einem Silizium-Wafer umfasst.

8. Verfahren zur Herstellung einer Anzeige mit den folgenden Schritten:
(a) es wird eine Vielzahl von nicht-linearen Schaltungselementen (150) bereit gestellt;
(b) es wird die Vielzahl nicht-linearer Schaltungselemente (150) in eine Aufschlämmung (153) eingegeben, um eine Mischung zu erzeugen;
(c) es wird ein Substrat (154) bereit gestellt, das eine Vielzahl von Vertiefungen (156) aufweist;
(d) es wird die Mischung auf das Substrat (154) aufgebracht; und
(e) es wird das Substrat (154) derart umgerührt, dass die Vielzahl nicht-linearer Schaltungselemente (150) in die Vielzahl von Vertiefungen (156) einfällt, um ein Feld nicht-linearer Schaltungselemente zu bilden;
wobei das Verfahren **dadurch gekennzeichnet ist, dass**
(f) das Substrat (154) auf einer Oberfläche eines Anzeigemediums (158) aufgebracht wird, das eine Vielzahl von Kapseln aufweist und jede Kapsel eine Vielzahl von in einer Flüssigkeit dispergierten Partikeln enthält, wobei eine Klebeschicht zwischen das Substrat (154) und die Oberfläche des Anzeigemediums (158) gefügt wird.

9. Verfahren nach Anspruch 8,
**dadurch gekennzeichnet, dass** das Anzeigemedium ein elektrophoretisches Anzeigemedium ist.

10. Verfahren nach den Ansprüchen 8 oder 9,
**dadurch gekennzeichnet, dass** die nicht-linearen Schaltungselemente Dünnschicht-Silizium-Transistoren oder Dünnschicht-Dioden sind.

11. Verfahren nach einem der Ansprüche 8 bis 10,
**dadurch gekennzeichnet, dass** der Schritt (c) die Erzeugung der Vielzahl von Vertiefungen und die Erzeugung leitfähiger Bahnen und einer Pixelelektrode in jeder Vertiefung umfasst.

12. Verfahren nach einem der Ansprüche 8 bis 11,
**dadurch gekennzeichnet, dass** im Schritt (a) ein erstes Substrat bereit gestellt wird, auf dem die nicht-linearen Schaltungselemente erzeugt werden, wobei die nicht-linearen Schaltungselemente von dem ersten Substrat getrennt werden und wobei im Schritt (c) ein zweites Substrat bereit gestellt wird.

13. Verfahren nach Anspruch 12,
**dadurch gekennzeichnet, dass** das erste Substrat eine Opferschicht ist, die weg geätzt wird, um die nicht-linearen Schaltungselemente abzutrennen.

## Revendications

1. Une méthode de fabrication d'écran (132), ladite méthode comprenant:
(a) la fourniture d'un premier substrat (123, 124b) sur lequel est disposée une couche de transfert (124a);
(b) la formation d'une matrice d'éléments de circuit non-linéaires (121) sur la couche de transfert (124a);
(c) la séparation de la matrice d'éléments de circuit non-linéaires (121) du premier substrat (123 ; 124b); et
(d) le placement de la matrice d'éléments de circuit non-linéaires (121) sur un second substrat,
la méthode étant **caractérisée par**:
(e) le placement du second substrat de façon adjacente à la surface d'un support d'affichage (112') comportant un grand nombre de capsules, chaque capsule comportant un grand nombre de particules dispersées dans un fluide, avec une couche adhésive (141) interposée entre ledit second substrat et ladite surface dudit support d'affichage (112').

2. Une méthode selon la revendication 1, **caractérisée en ce que** le support est un support d'affichage électrophorétique.

3. Une méthode selon l'une ou l'autre des revendications précédentes, **caractérisée en ce que** les éléments de circuit non-linéaires sont des transistors à couches minces, des diodes à couches minces, des diodes métal-isolant-métal, des diodes dos à dos ou des diodes tête-bêche.

4. Une méthode selon l'une quelconque des revendications précédentes, **caractérisée en ce que** l'étape (c) comporte l'enlèvement du grand nombre d'éléments de circuit non-linéaires.

5. Une méthode selon l'une des revendications 1 à 3, **caractérisée en ce que** l'étape (d) comporte le collage des éléments de circuit non-linéaires sur le second substrat.

6. Une méthode selon l'une des revendications précédentes, **caractérisée en ce que** l'étape (d) comporte le placement des éléments de circuit non-linéaires sur un substrat en verre ou en plastique, une feuille de métal, du papier ou un substrat souple.

7. Une méthode selon l'une des revendications précédentes, **caractérisée en ce que** l'étape (b) comporte la formation d'éléments de circuit non-linéaires sur une plaque de silicium.

8. Une méthode de fabrication d'écran, ladite méthode comprenant:
(a) la fourniture d'un grand nombre d'éléments de circuit non-linéaires (150);
(b) le placement du grand nombre d'éléments de circuit non-linéaires (150) dans une pâte (153) afin de former un mélange;
(c) la fourniture d'un substrat (154) comportant un grand nombre d'impressions (156);
(d) le placement du mélange sur le substrat (154); et
(e) l'agitation du substrat (154) de telle façon que le grand nombre d'éléments de circuit non-linéaires (150) tombe dans le grand nombre d'impressions (156) pour former une matrice d'éléments de circuit non-linéaires:
la méthode étant **caractérisée par**:
(f) le placement du substrat (154) sur la surface d'un support d'affichage (158) comportant un grand nombre de capsules, chaque capsule comportant un grand nombre de particules dispersées dans un fluide, avec une couche adhésive interposée entre ledit substrat (154) et ladite surface dudit support d'affichage (158).

9. Une méthode selon la revendication 8, **caractérisée en ce que** le support est un support d'affichage électrophorétique.

10. Une méthode selon la revendication 8 ou 9, **caractérisée en ce que** les éléments de circuit non-linéaires comportent des transistors au silicium à couches minces ou des diodes à couches minces.

11. Une méthode selon l'une des revendications 8 à 10, **caractérisée en ce que** l'étape (c) comporte la formation d'un grand nombre d'impressions et la formation de pistes conductrices et d'une électrode de pixel dans chaque impression.

12. Une méthode selon l'une des revendications 8 à 11, **caractérisée en ce que** l'étape (a) comporte la fourniture d'un premier substrat, la formation d'éléments de circuit non-linéaires sur le premier substrat, et la séparation des éléments de circuit non-linéaires du premier substrat; et que l'étape (c) comporte la fourniture d'un second substrat.

13. Une méthode selon la revendication 12 **caractérisée en ce que** le premier substrat comporte une couche sacrificielle qui est attaquée afin de séparer les éléments de circuit non-linéaires.
